# EUROPEAN PATENT APPLICATION

(11) **EP 2 784 812 A2**
(43) Date of publication of application: **01.10.2014**
(21) Application number: 14160909.9
(22) Date of filing: 20.03.2014
(51) Int. Cl.: H01L 23/427

(54) **Heat pipe sink for high power density**

(30) Priority: 26.03.2013 US 201361805202 P; 07.03.2014 US 201414200761
(71) Applicant: GE Energy Power Conversion Technology Ltd, Rugby Warwickshire CV21 1BU (GB)
(72) Inventor: Opila, Daniel Francis, Pittsburgh PA Pennsylvania 15238-2808 (US); Fatschel, Stephen, Seven Fields PA Pennsylvania 16046 (US)
(74) Representative: Serjeants LLP

(57) **Abstract**

A heat sink (5) is disclosed including a cold plate (30), a plurality of heat pipes (20), and a plurality of fins (10). The cold plate (30) has a first surface arranged substantially vertical and adapted to thermally couple to a heat source. Each of the plurality of heat pipes (20) have an evaporator section arranged substantially vertical and thermally coupled to the cold plate (30), a condenser section arranged at an incline, and a single bend section coupling the evaporator section and the condenser section. The plurality of fins (10) are thermally coupled to the condenser sections of the plurality of heat pipes (20).

## Description

### BACKGROUND OF THE INVENTION

### 1. Field of the Invention

The present invention pertains to heat sinks and, in particular, to a heat sink device having a plurality of heat pipes each having a single bend.

### 2. Description of the Related Art

Electrical semiconductor devices such as large scale integrated circuits, voltage regulators, current switching devices, high speed or high current circuits, and other similar devices, generate an amount of heat that can be detrimental to their operation. Thus, it is desirable to cool the semiconductor device sufficiently to maintain the operating temperature of the semiconductor device at or below a predetermined temperature.

Generally, to cool semiconductor devices, the heat generated by the semiconductor device is transferred away from the device and dissipated. A number of techniques are used to transfer and dissipate the heat from semiconductor devices. As an example, heat pipes have been used to move heat away from semiconductor devices and fins have been used with the heat pipes to dissipate the transferred heat to the air.

Heat pipes are enclosed pipes that transfer heat through the evaporation and condensation of a fluid contained in the heat pipe. More specifically, a heat pipe includes an evaporator section which is located near a heat source (i.e. the semiconductor device) and a condenser section which is located away from the heat source. The heat from the heat source causes fluid located in the evaporator section to evaporate. The vapor then moves to the condenser section, thus transferring heat generated by the heat source to the condenser section.

The condenser section of a heat pipe is often constructed to be in thermal contact with a series of metallic fins. The heat of the vapor in the condenser section is transferred into the fins where the large surface area of the fins aids in dissipating the heat into the air. Heat sinks have also used a blower to blow air over the fins to further aid the dissipation process. As the heat of the vapor is dissipated, the vapor cools off and condenses. The condensed fluid is then transferred back to the evaporator section to be heated up again. The cycle of evaporation and condensation continues, thus transferring and dissipating the heat generated by the heat source, and thereby cooling the heat source. However, the use of heat pipes with heat sinks has not been without difficulty.

For cooling semiconductor devices which generate large amounts of heat (e.g., power transistors), the use of heat sinks including heat pipes has been undesirable. In order to transfer and dissipate the large amounts of heat, more heat pipes and larger and/or more fins are used. Coupling each heat pipe with its own set of fins would create a prohibitively large device. Thus, to reduce the size of the heat sink, multiple heat pipes are coupled to the same set of fins. In order to efficiently dissipate heat, the heat pipes are each coupled to different areas of a fin. However, previous attempts have resulted in heat sinks having heat pipes and/or fins with complex geometries. Geometric complexities in heat pipes such as multiple bends and/or complex bends increases the manufacturing costs of a heat sink.

Thus, there is a need for an improved heat sink which uses heat pipes for semiconductor devices which generate large amounts of heat.

### SUMMARY OF THE INVENTION

In one embodiment, a heat sink is provided. The heat sink includes a cold plate, a plurality of heat pipes, and a plurality of fins. The cold plate has a first surface arranged substantially vertical and adapted to thermally couple to a heat source. Each of the plurality of heat pipes have an evaporator section arranged substantially vertical and thermally coupled to the cold plate, a condenser section arranged at an incline, and a single bend section coupling the evaporator section and the condenser section. The plurality of fins are thermally coupled to the condenser sections of the plurality of heat pipes.

In another embodiment, an arrangement of heat sinks adapted to thermally coupled to one or more heat sources is provided. The arrangement of heat sink includes a plurality of heat sinks disposed adjacent to each other. Each of the plurality of heat sinks includes a cold plate, a plurality of heat pipes, and a plurality of fins. The cold plate has a first surface arranged substantially vertical and adapted to thermally couple to at least one of the one or more heat sources. Each of the heat pipes has an evaporator section arranged substantially vertical and thermally coupled to the cold plate, a condenser section arranged at an incline, and a single bend section coupling the evaporator section and the condenser section. The plurality of fins are thermally coupled to the condenser sections of the plurality of heat pipes. The plurality of heat sinks can include a first heat sink and a second heat sink and at least one characteristic of the cold plate, the heat pipes, or the fins can be varied between the first heat sink and the second heat sink. For example, a density of the fins included in the second heat sink can be greater than a density of the fins included in the first heat sink, or a length of the condenser sections of the plurality of heat pipes and a number of fins included in the second heat sink can be greater than a length of the condenser sections of the plurality of heat pipes and a number of fins included in the first heat sink. The at least one characteristic of the cold plate, the heat pipes, or the fins can be varied between the first heat sink and the second heat sink based on an expected thermal loading.

In another embodiment a system is provided and includes an electronic heat source and one or more heat sinks. The one or more heat sinks are thermally coupled to the electronic heat source and adapted to dissipate heat generated by the electronic heat source. The one or more heat sinks each include a cold plate, a plurality of heat pipes, and a plurality of fins. The cold plate has a first surface arranged substantially vertical and adapted to thermally couple to the electronic heat source. Each of the plurality of heat pipes has an evaporator section arranged substantially vertical and thermally coupled to the cold plate, a condenser section arranged at an incline, and a single bend section coupling the evaporator section and the condenser section. The plurality of fins are thermally coupled to the condenser section of the plurality of heat pipes.

### BRIEF DESCRIPTION OF THE DRAWINGS

FIG. 1 is an isometric view of a heat sink according to an embodiment of the inventive concept;
FIG. 2 is a side view of the heat sink shown in FIG. 1;
FIG. 3 is an end view of the heat sink shown in FIG. 1;
FIG. 4 is a side view of a heat pipe in accordance with embodiments of the inventive concept;
FIGS. 5 and 6 are isometric views of arrangements of heat sinks in accordance with embodiments of the inventive concept; and
FIG. 7 is a side view of a system including a heat sink in accordance with an embodiment of the inventive concept.

### DETAILED DESCRIPTION OF EXEMPLARY EMBODIMENTS

As used herein, the singular form of "a", "an", and "the" include plural references unless the context clearly dictates otherwise. As used herein, the statement that two or more parts or components are "coupled" shall mean that the parts are joined or operate together either directly or indirectly, i.e., through one or more intermediate parts or components, so long as a link occurs. As used herein, "directly coupled" means that two elements are directly in contact with each other. As used herein, "fixedly coupled" or "fixed" means that two components are coupled so as to move as one while maintaining a constant orientation relative to each other. As employed herein, the term "number" shall mean one or an integer greater than one (i.e., a plurality).

Directional phrases used herein, such as, for example and without limitation, top, bottom, left, right, upper, lower, front, back, and derivatives thereof, relate to the orientation of the elements shown in the drawings and are not limiting upon the claims unless expressly recited therein.

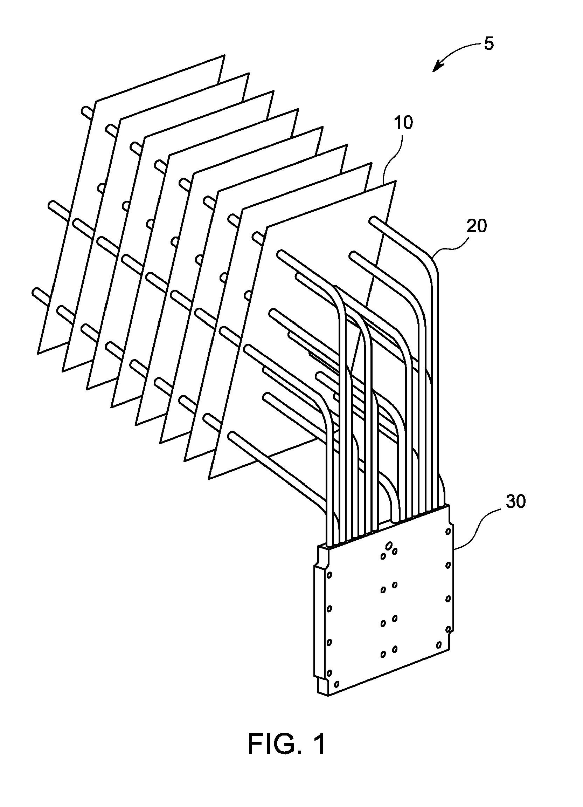

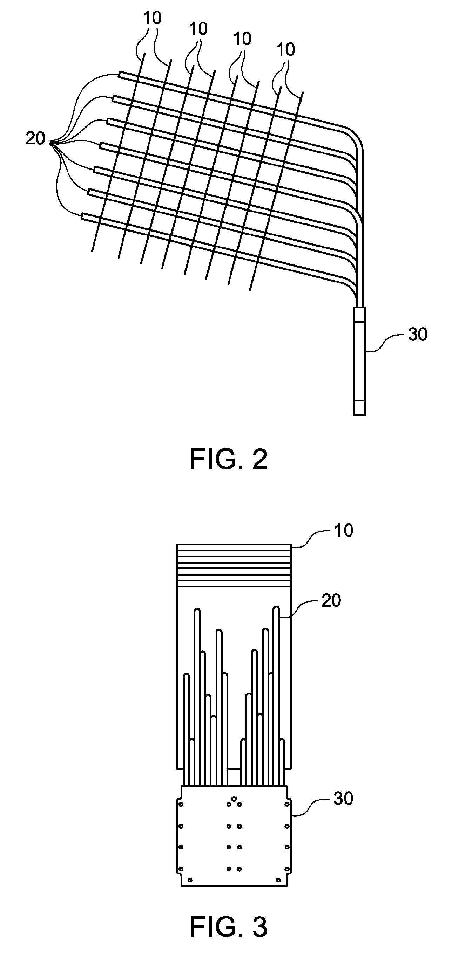

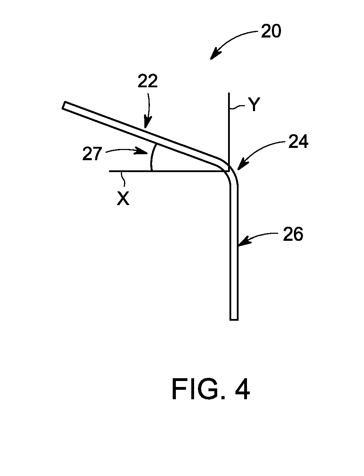

FIG. 1 is an isometric schematic of an exemplary embodiment of a heat sink 5 implemented according to principles of the present invention. FIGS. 2 and 3 are side view and end view schematics, resnectively, of the heat sink 5 illustrated in FIG. 1. FIG. 4 is a side view schematic of an exemplary heat pipe 20 which is adapted for use in the heat sink 5 illustrated in FIGS. 1-3.

Referring to FIGS. 1-3, the heat sink 5 includes a plurality of fins 10, a plurality of heat pipes 20, and at least one cold plate 30. The heat pipes 20 each include an evaporator section 26, a bend section 24, and a condenser section 22 (see FIG. 4). As shown in FIGS. 1-3, the evaporator section 26 is arranged substantially vertically and connected to the cold plate 30. The heat pipes 20 also include the condenser section 22 which is inclined with respect to a horizontal plane and extends through a plurality of fins 10. The evaporator section 26 and the condenser section 22 of each heat pipe 20 are connected by a single straight bend section 24.

The evaporator section 26 and the condenser section 22 are each substantially straight pieces of piping. In the exemplary embodiment, the evaporator sections 26 of the heat pipes 20 extend in parallel with each other and the condenser sections 22 of the heat pipes 20 extend in parallel with each other. The bend section 24 includes a piece of piping having a single straight bend. As employed herein, the term "single straight bend" means a single bend with a substantially constant radius and without a substantial twist or skew. The geometry of each heat pipe 20 has minimal complexity.

A plurality of heat pipes 20 are thermally coupled to the cold plate 30. Although FIGS. 1-3 show sixteen heat pipes 20 thermally coupled to the cold plate 30, the present invention is not limited thereto. It is contemplated that any number of heat pipes 20 greater than two can be thermally coupled to the cold plate 30 while remaining within the scope of the invention.

The vertical evaporator sections 26 of adjacent heat pipes 20 have different lengths. As such, the condenser sections 22 of adjacent heat pipes 20 are spaced apart from each other and extend through different areas of the fins 10. As illustrated in FIG. 1, the heat pipes 20 are spread across the area of the fins 10. Spreading out the locations where the heat pipes 20 extend through the fins 10 increases the efficiency of the fins 10 in dissipating the heat of the heat pipes 20 as compared to a configuration wherein the heat pipes 20 extend through the same area of the fins 10.

The condenser section 22 of the heat pipe 20 is inclined with respect to a horizontal plane by an angle 27 (see FIG. 4). For example and without limitation, the angle 27 may be within a range of about 5-40 degrees, or preferably about 5-20 degrees.

As illustrated in FIGS. 1-3, the evaporator section 26 of the heat pipes 20 and the cold plate 30 are arranged substantially vertically. However, it will be appreciated that the condenser section 22 of the heat pipes 20 and the cold plate 30 may also be tilted with respect to a vertical axis.

As illustrated in FIGS. 1-3, the heat pipes 20 are inserted into an upper surface of the cold plate 30. However, it is contemplated that the heat pipes 20 may be connected to the cold plate 30 in any suitable manner which thermally couples them while remaining within the scope of the invention. In an embodiment, the cold plate 30 may include an interior chamber (e.g. a vapor chamber) and the heat pipes 20 may be coupled to an upper surface of the cold plate 30 and be fluidly connected with the interior chamber of the cold plate 30. Additionally, it is contemplated that the heat pipes 20 may be attached to the cold plate 30 by, for example and without limitation, welding, soldering, or by using a suitable thermally conductive adhesive.

The fins 10 are spaced apart from each other. The number, spacing, size, and/or thickness of the fins 10 can be varied. For example, the number, spacing, size, and/or thickness of the fins 10 can be optimized based on an expected thermal loading of different areas of the fins 10.

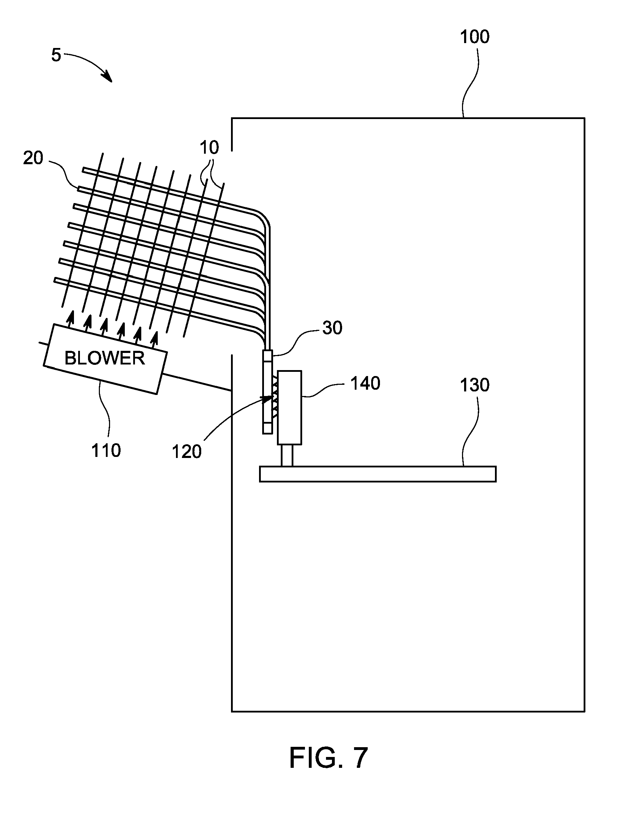

The cold plate 30 is adapted to thermally couple with a heat source (see FIG. 7). The cold plate 30 may be thermally coupled with the heat source in any suitable manner such as, without limitation, by a thermally conductive adhesive.

FIG. 4 is a side view schematic of an exemplary heat pipe 20 according to principles of the present invention. The heat pipe 20 shown in FIG. 4 is readily adapted for use in the heat sinks 5 shown in FIGS. 1-3. For example, the heat pipes 20 shown in FIGS. 1-3 are similar except that lengths of the evaporator sections 26 of the heat pipes 20 are varied.

The heat pipe 20 operates to transfer heat from the evaporator section 26 to the condenser section 22 through the evaporation and condensation of a liquid included in the heat pipe 20. More particularly, when the evaporator section 26 of the heat pipe 20 is heated, the liquid evaporates into a vapor. The vapor moves to the condenser section 22 where it cools and condenses. The liquid then moves back to the evaporator section 26 with the assistance of gravity. The cycle of evaporation and condensation transfers thermal energy from the evaporator section 26 to the condenser section 22 of the heat pipe 20. Fins 10 thermally coupled to the condenser section 22 assist to dissipate the heat from the condenser section 22. The heat pipes 20 may also include a wick which is formed on an interior of the heat pipe 20 to assist with moving the condensed liquid to the evaporator section 26.

The condenser section 22 is inclined with respect to horizontal by an angle 27 so as to utilize gravity to assist in returning condensed liquid to the evaporator section 26. As noted elsewhere herein, the angle 27 may be, for example and without limitation, in a range of 5-40 degrees, and preferably within a range of 5-20 degrees.

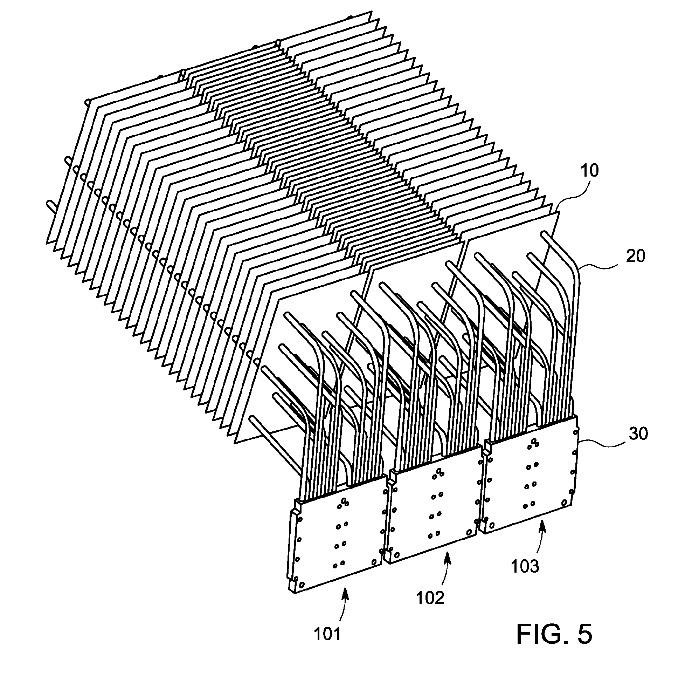

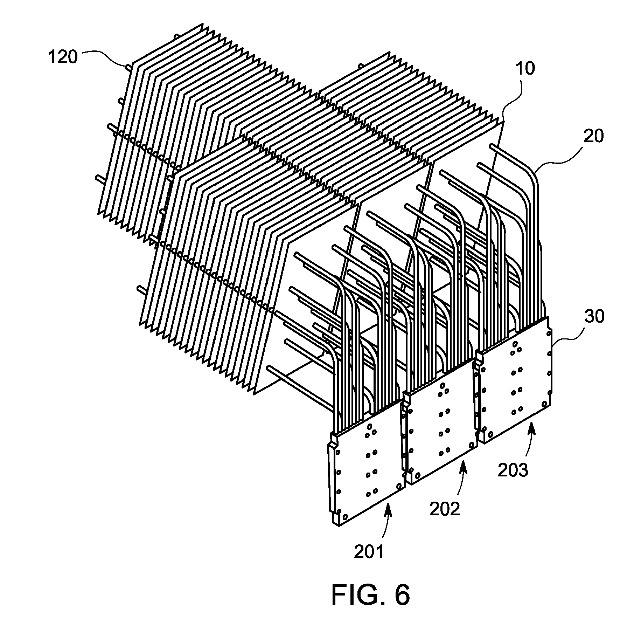

FIGS. 5 and 6 illustrate arrangements of heat sinks in accordance with embodiments of the present inventive concept. Referring first to FIG. 5, a plurality of heat sinks 101, 102, and 103 are arranged together so as to dissipate heat from one or more heat sources. As illustrated in FIG. 5, heat sinks 101, 102, and 103 each include a cold plate 30, a plurality of heat pipes 20 attached to the cold plate 30, and a plurality of fins 10 attached to a condenser section of the heat pipes 20. The heat sinks 101, 102, and 103 are similar to the heat sink 5 shown in FIGS. 1-3. However, characteristics of the heat sinks 101, 102, and 103 are varied. For example, heat sinks 101 and 103 have similar characteristics, but heat sink 102 has a higher density of fins 10 (i.e. more fins per unit of length) thermally coupled to the condenser section of the heat pipes 20 than heat sinks 101 and 103, thus allowing heat sink 102 to dissipate a larger amount of heat than heat sinks 101 or 103.

Continuing to refer to FIG. 5, the heat sinks 101, 102, and 103 are arranged such that their respective cold plates 30 are coplanar and adjacent to each other. The coplanar arrangement allows multiple cold plates 30 to be easily thermally coupled to a heat source (such as a number ofIGBTs). Additionally, a thermally conductive member, such as, without limitation, a metal piece, can be attached across the cold plates 30 of heat sinks 101, 102, and 103 so as to both attach the heat sinks 101, 102, and 103 to each other and to thermally couple the heat sinks 101, 102, and 103 to one or more heat sources.

Referring to FIG. 6, a plurality of heat sinks 201, 202, and 203 are arranged together so as to dissipate heat from one or more heat sources. In the embodiment illustrated in FIG. 6, heat sinks 201 and 203 are similar to each other and each include a cold plate 30, a plurality of heat pipes 20 thermally coupled with the cold plate 30, and a plurality of fins 10 thermally coupled with a condenser section of the heat pipes 20. Heat sink 202 is similar to heat sinks 201 and 203 except that heat sink 202 uses heat pipes 120 which have a longer condenser section than heat pipes 20. Additionally, heat sink 202 includes a larger number of fins 10 than heat sinks 201 and 203. The heat pipes 120 with a longer condenser section and larger number of fins 10 allow heat sink 202 to dissipate more heat than heat sinks 201 or 203.

While the embodiments illustrated in FIGS. 5 and 6 include multiple heat sinks arranged together while varying the density of fins coupled to the condenser section of the heat pipes or varying the length of the condenser section of the heat pipes and the number of fins coupled to the condenser section of the heat pipes, other characteristics of the heat sinks, such as, for example and without limitation, the number of heat pipes used in each heat sink or the size of each heat sink, can be varied while remaining within the scope of the invention.

Characteristics of each heat sink may be determined based on, for example and without limitation, expected thermal loading. For example, if it is anticipated that a heat source or arrangement of heat sources will provide a higher thermal load at a central area and a lower thermal load at an outer area, an arrangement of heat sinks which provides a higher heat dissipation to a central area, such as, for example, the arrangements shown in FIGS. 5 and 6, can be used. While the embodiments of FIGS. 5 and 6 can dissipate a higher thermal load in a central area of a heat source or heat sources, heat sinks can be arranged with varying characteristics determined to dissipate various thermal loads while remaining within the scope of the invention.

FIG. 7 illustrates a system in accordance with principles of the present invention according to one exemplary embodiment. The system includes a heat sink 5 including heat pipes 20, cold plate 30, and fins 10 which are similar to the heat sink 5 described above with respect to FIGS. 1-3. However, the arrangements of heat sinks in the embodiments shown in FIGS. 5-6 can also be adapted for use in the system shown in FIG. 7. The system additionally includes an enclosure 100, a blower 110, a thermally conductive adhesive 120, a circuit board 130, and a heat source 140.

As shown in FIG. 7, the evaporator section 26 of the heat pipes 20 is disposed primarily inside the enclosure 100 and the condenser section 22 of the heat pipes 20 is disposed primarily outside the enclosure 100. With this arrangement, the heat source 140, which is in close proximity with the evaporator section 26 of the heat pipes 20, may be shielded from the outside environment.

The blower 110 is adapted to blow air across the fins 10. Including the blower 110 increases the amount of heat dissipated by the fins 10 compared to a heat sink 5 which operates through only natural convection. In the embodiment shown in FIG. 7, the blower 110 is disposed below the fins 10. However, it is contemplated that the blower 110 may be disposed at any suitable location to blow air over the fins 10 without departing from the scope of the invention. Furthermore, it is contemplated that the blower 110 may be omitted without departing from the scope of the invention.

In the embodiment shown in FIG. 7, the heat source 140 is thermally coupled to the cold plate 30 with a thermally conductive adhesive 120. However, the heat source 140 may be coupled to the cold plate 30 in any suitable manner which thermally couples the heat source 140 and the cold plate 30 while remaining within the scope of the invention.

The heat source 140 may be any type of device that generates heat, such as, without limitation, semiconductor devices which generate a large amount of heat. In one exemplary embodiment, the heat source 140 is an insulated gate bipolar transistor (IGBT). However, it will be appreciated that the heat source 140 may be a variety of different semiconductor devices or other devices which generate heat.

In the claims, any reference signs placed between parentheses shall not be construed as limiting the claim. The word "comprising" or "including" does not exclude the presence of elements or steps other than those listed in a claim. In a device claim enumerating several means, several of these means may be embodied by one and the same item of hardware. The word "a" or "an" preceding an element does not exclude the presence of a plurality of such elements. In any device claim enumerating several means, several of these means may be embodied by one and the same item of hardware. The mere fact that certain elements are recited in mutually different dependent claims does not indicate that these elements cannot be used in combination.

Although the invention has been described in detail for the purpose of illustration based on what is currently considered to be the most practical and preferred embodiments, it is to be understood that such detail is solely for that purpose and that the invention is not limited to the disclosed embodiments, but, on the contrary, is intended to cover modifications and equivalent arrangements that are within the spirit and scope of the appended claims. For example, it is to be understood that the present invention contemplates that, to the extent possible, one or more features of any embodiment can be combined with one or more features of any other embodiment.

## Claims

1. A heat sink (5; 101-103; 201-203), comprising:
a cold plate (30) having a first surface arranged substantially in a first direction (e.g., vertical) and adapted to thermally couple to a heat source (e.g., including one or more semiconductor devices such as insulated gate bipolar transistors);
a plurality of heat pipes (20), each of the heat pipes (20) having an evaporator section (26) arranged substantially in the first direction and thermally coupled to the cold plate (30), a condenser section (22) arranged at an incline with respect to a second direction (e.g., horizontal) which is orthogonal to the first direction, and a single bend section (24) coupling the evaporator section (26) to the condenser section (22); and
a plurality of fins (10) thermally coupled to the condenser sections (22) of the plurality of heat pipes (20).

2. A heat sink (5; 101-103; 201-203) according to claim 1, wherein the evaporator section (26) of a first heat pipe (20) of the plurality of heat pipes has a first length and the evaporator section (26) of a second heat pipe (20) of the plurality of heat pipes has a second length, wherein the first length and the second length are different.

3. A heat sink (5; 101-103; 201-203) according to claim 1 or claim 2, wherein evaporator sections (26) of adjacent heat pipes (20) have different lengths.

4. A heat sink (5; 101-103; 201-203) according to any preceding claim, wherein the single bend section (24) has only a single straight bend.

5. A heat sink (5; 101-103; 201-203) according to any preceding claim, wherein in each of the heat pipes (20), the condenser section (22) is inclined in a range of about 5 - 45 degrees with respect to the second direction, and optionally in a range of about 5 - 20 degrees with respect to the second direction.

6. A heat sink (5; 101-103; 201-203) according to any preceding claim,
wherein the evaporator section (26) and the condenser section (22) of each of the plurality of heat pipes (20) are substantially straight.

7. A heat sink (5; 101-103; 201-203) according to any preceding claim,
wherein the evaporator sections (26) of the plurality of heat pipes (20) extend in parallel with each other and the condenser sections (22) of the plurality of heat pipes (20) extend in parallel with each other, and are optionally spaced apart from each other.

8. A heat sink (5) according to any preceding claim, wherein the cold plate (30) resides within an enclosure (100), and the condenser sections (22) of the plurality of heat pipes (20) reside outside of said enclosure (100), and wherein the condenser sections (22) are optionally directly exposed to outdoor air cooling.

9. An arrangement of heat sinks adapted to thermally couple to one or more heat sources, the arrangement of heat sinks comprising:
a plurality of heat sinks (101-103; 201-203) disposed adjacent to each other, each heat sink being according to any preceding claim and where the cold plate (30) of each heat sink is adapted to thermally couple to at least one of the one or more heat sources.

10. An arrangement of heat sinks according to claim 9, wherein the first surfaces of the cold plates (30) corresponding to each of the plurality of heat sinks are substantially coplanar.

11. An arrangement of heat sinks according to claim 9 or claim 10, wherein the plurality of heat sinks includes a first heat sink (101; 201) and a second heat sink (102; 202) and at least one characteristic of the cold plate (30), the heat pipes (20), or the fins (10) is varied between the first heat sink (101; 201) and the second heat sink (102; 202), optionally based on an expected thermal loading.

12. A system comprising:
an electronic heat source (140);
one or more heat sinks (5) thermally coupled to the electronic heat source (140) and adapted to dissipate heat generated by the electronic heat source (140), the one or more heat sinks (5) each comprising:
a cold plate (30) having a first surface arranged substantially in a first direction (e.g., vertical) and adapted to thermally couple to the electronic heat source (140);
a plurality of heat pipes (20), each of the heat pipes (20) having an evaporator section (26) arranged substantially in the first direction and thermally coupled to the cold plate (30), a condenser section (26) arranged at an incline with respect to a second direction (e.g., horizontal) which is orthogonal to the first direction, and a single bend section (24) coupling the evaporator section (26) and the condenser section (22); and
a plurality of fins (10) thermally coupled to the condenser section (22) of the plurality of heat pipes (20).

13. A system according to claim 12, further comprising:
an enclosure (100) configured to substantially enclose the electronic heat source (140) and the evaporator section (26) of the one or more heat sinks (5),
wherein the condenser section (22) of the one or more heat sinks (5) extends outside the enclosure (100).

14. A system according to claim 12 or claim 13, further comprising:
a blower (110) adapted to blow air over the plurality of fins (10) of at least one of the one or more heat sinks (5).

15. A system according to any of claim 12 to 14, wherein the one or more heat sinks thermally coupled to the electronic heat source (140) is a plurality of heat sinks thermally coupled to the electronic heat source through a thermally conductive member disposed between the cold plates corresponding to the plurality of heat sinks and the electronic heat source.
